(19) Europäisches Patentamt
European Patent Office
Office européen des brevets

(11) **EP 3 492 934 B1**

(12) **FASCICULE DE BREVET EUROPEEN**

(45) Date de publication et mention de la délivrance du brevet:
**01.04.2020   Bulletin 2020/14**

(51) Int Cl.:
***G01R 31/08*** *(2020.01)*      *G01R 31/12* *(2020.01)*

(21) Numéro de dépôt: **18208730.4**

(22) Date de dépôt: **27.11.2018**

(54) **DISPOSITIF ET PROCÉDÉ DE DÉTECTION ET DE LOCALISATION D'UN DÉFAUT SURVENANT DANS UN CÂBLE**

VORRICHTUNG UND VERFAHREN ZUR ERKENNUNG UND LOKALISIERUNG EINES KABELFEHLERS

APPARATUS AND METHOD FOR DETECTION AND LOCALIZATION OF CABLE FAULT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.12.2017   FR 1761546**

(43) Date de publication de la demande:
**05.06.2019   Bulletin 2019/23**

(73) Titulaires:
- **Commissariat à l'Énergie Atomique et aux Énergies Alternatives 75015 Paris (FR)**
- **Safran Electrical & Power 31702 Blagnac (FR)**

(72) Inventeurs:
- **ALBERTO, Diego 38700 CORENC (FR)**
- **HEIRIES, Vincent 38430 SAINT-JEAN-DE-MOIRANS (FR)**
- **TOUFFLET, Raphaël 38000 GRENOBLE (FR)**
- **TREBOSC, Christophe 31702 BLAGNAC CEDEX (FR)**
- **BUSSY, Emmanuel 31702 BLAGNAC CEDEX (FR)**

(74) Mandataire: **GIE Innovation Competence Group 310, avenue Berthelot 69372 Lyon Cedex 08 (FR)**

(56) Documents cités:
WO-A2-2011/118923      DE-A1-102010 051 213
JP-A- 2001 021 607      US-A1- 2017 115 256

**Description**

**DOMAINE TECHNIQUE**

Le domaine technique de l'invention est la détection et la localisation de défauts survenant dans un câble conducteur d'électricité.

**ART ANTERIEUR**

La détection précoce et la localisation de défauts apparaissant dans des installations électriques, notamment de moyenne ou de haute tension, est un point particulièrement important pour prévenir la survenue de dégradations majeures. Dans ce type d'installations, des connectiques défectueuses, ou des dommages mécaniques causés sur un câble peuvent engendrer la formation d'arcs électriques. Leur détection, à un stade précoce, permet d'éviter la formation de courts-circuits ou d'incendies. En complément de leur détection, la localisation de défauts dans un circuit électrique facilite les opérations de maintenance, en particulier dans le cas de circuits électriques complexes ou peu accessibles.

Des techniques de détection basées sur la propagation de signaux électriques et l'analyse de leur réflexion, sous l'effet de l'apparition de défauts, ont été développées, mais ces techniques peuvent être complexes à mettre en œuvre et s'accompagnent de certaines limitations, en particulier la détection de faux positifs. Elles nécessitent par ailleurs une bonne maîtrise de l'impédance des circuits analysés.

La demande de brevet WO2014/001466 décrit un dispositif basé sur l'utilisation d'un capteur acoustique, couplé à un moyen de détection électrique, pour localiser un arc électrique dans un câble. Plus précisément, on mesure un retard entre une signature électrique et une signature acoustique d'un arc électrique, les signatures étant enregistrées en un même point du câble. On tire alors profit de la lenteur relative à laquelle se propage l'onde de déformation mécanique, ou onde acoustique, cette dernière permettant de localiser la présence d'un arc électrique en prenant en compte une vitesse de propagation de l'onde acoustique le long du câble. Dans cette demande, on a considéré que la vitesse de propagation de l'onde acoustique dans un câble est uniforme. Elle peut varier, en particulier en fonction de la température. Le long d'un même câble, la vitesse de propagation de l'onde est supposée constante.

Le document WO2011/118923 décrit un dispositif pour déterminer une position tridimensionnelle d'un défaut dans un câble à l'aide de trois capteurs acoustiques. La vitesse de propagation de l'onde acoustique est supposée constante.

Le document DE102010051213 décrit également un procédé pour localiser un défaut dans un câble électrique, la vitesse de propagation de l'onde acoustique étant supposée constante.

Le document JP2001/021607 décrit un procédé pour localiser un défaut dans un câble électrique en utilisant des capteurs acoustiques. Les capteurs sont disposés à une distance très faible les uns des autres, typiquement égale à 25 mm.

Le document US2017115256 décrit un procédé pour déterminer un défaut d'une ligne électrique entre deux pylônes. Le dispositif est basé sur une détection d'une onde acoustique audible, se propageant dans l'air selon une vitesse de propagation fixe.

La demande de brevet FR3046232 décrit un procédé permettant une détection de la survenue d'un arc électrique dans un système à partir d'un capteur acoustique.

Les inventeurs proposent un procédé amélioré, permettant une localisation plus précise d'un défaut électrique survenant dans un câble. Par ailleurs, le procédé proposé convient également à la détection d'un défaut d'origine mécanique, par exemple un choc ou une pression s'exerçant sur le câble.

**EXPOSE DE L'INVENTION**

Un premier objet de l'invention est un procédé de détection et de localisation d'un défaut affectant un câble, le câble étant destiné à conduire un courant électrique, le procédé comportant les étapes suivantes :

    a) disposition d'un premier capteur et d'un deuxième capteur, le premier capteur étant apte à détecter la survenue d'un défaut dans le câble, le deuxième capteur étant apte à détecter une onde acoustique se propageant le long du câble, suite à la survenue du défaut dans le câble;
    b) détection de la survenue du défaut

    -   par le premier capteur, à un premier instant,
    -   et par le deuxième capteur, à un deuxième instant, postérieur ou identique au premier instant ;

    c) prise en compte d'une vitesse de propagation de l'onde acoustique générée par le défaut ;
    d) estimation d'une position du défaut en fonction du premier instant et du deuxième instant, en se basant sur la vitesse de propagation résultant de l'étape c) ;
    e) détermination d'une vitesse de propagation de référence en fonction de la position du défaut résultant de l'étape d), et comparaison de ladite vitesse de référence avec la vitesse de propagation prise en compte lors de l'étape c) ;
    f) en fonction de la comparaison,

        ■  validation de la position résultant de l'étape d) ;
        ■  ou réitération des étapes c) à f) en ajustant, lors de l'étape c) la vitesse de propagation prise en compte.

Selon un mode de réalisation, dit acoustique-acoustique, le premier capteur est un capteur acoustique, apte à détecter l'onde acoustique se propageant le long du câble. Lors de l'étape d), l'estimation de la position du défaut peut alors être obtenue en :

di) calculant un écart temporel entre le premier instant et le deuxième instant;
dii) comparant une distance entre les capteurs, le long du câble, à une distance obtenue en multipliant la vitesse de propagation de l'onde acoustique, prise en compte lors de

l'étape c), par l'écart temporel. La comparaison peut notamment être une soustraction. Selon ce mode de réalisation, le premier capteur acoustique et le deuxième capteur acoustique sont espacés l'un de l'autre.

De préférence, selon ce mode de réalisation, lors de l'étape d), la position du défaut est située entre le premier capteur et le deuxième capteur.

Selon un autre mode de réalisation, dit électrique-acoustique, le premier capteur est un capteur électrique, apte à mesurer un signal électrique se propageant le long du câble, ainsi qu'une variation du signal électrique générée par le défaut. Lors de l'étape d), l'estimation de la position du défaut peut alors être obtenue en :

di) calculant un écart temporel entre le premier instant et le deuxième instant;
dii) multipliant la vitesse de propagation de l'onde acoustique, prise en compte lors de l'étape c), par l'écart temporel.

Quel que soit le mode de réalisation :

- lors d'une réitération des étapes c) à f), la vitesse de propagation prise en compte lors de l'étape c) d'une itération correspond à la vitesse de référence déterminée lors de l'étape e) de l'itération précédente.
- lors de l'étape e), la vitesse de référence est déterminée à l'aide d'une fonction de propagation décrivant l'évolution de la vitesse de propagation d'une onde acoustique, dans le câble, en fonction de la distance de propagation de l'onde acoustique. La fonction de référence est préalablement déterminée.

Un deuxième objet de l'invention est un dispositif de détection et de localisation de la position d'un défaut survenant dans un câble, le câble étant apte à conduire un courant électrique, le dispositif comportant :

- un premier capteur, apte à détecter la survenue d'un défaut dans le câble électrique;
- un deuxième capteur étant apte à détecter une onde acoustique se propageant le long du câble, suite à la survenue du défaut dans le câble;
- un processeur, relié au premier capteur et au deuxième capteur, et configuré pour exécuter des instructions pour la mise en œuvre des étapes b) à f) du procédé selon le premier objet de l'invention, à partir de signaux de détection provenant de chaque capteur.

Le premier capteur peut être un capteur apte à détecter une onde acoustique se propageant le long du câble suite à la survenue du défaut dans le câble. Dans ce cas, le premier capteur acoustique et le deuxième capteur acoustique sont espacés l'un de l'autre. Alternativement, le premier capteur peut être un capteur électrique, apte à mesurer un paramètre électrique relatif au courant circulant dans le câble.

Un troisième objet de l'invention est un procédé de détection d'un défaut affectant un câble, le câble étant destiné à conduire un courant électrique, le procédé comportant les étapes suivantes :

a) disposition d'un premier capteur et d'un deuxième capteur, le premier capteur et le deuxième capteur étant aptes à détecter une onde acoustique se propageant le long du câble, suite à la survenue dudit défaut dans le câble entre lesdits capteurs ;
b) détection de la survenue du défaut

- par le premier capteur, à un premier instant,
- et par le deuxième capteur, à un deuxième instant, postérieur au premier instant ;

c) prise en compte d'une vitesse de propagation de l'onde acoustique générée par le défaut ;
d) estimation d'une position du défaut en fonction du premier instant et du deuxième instant, en se basant sur la vitesse de propagation résultant de l'étape c) ;

le procédé étant caractérisé en ce que la distance entre le premier capteur et le deuxième capteur, le long du câble, est supérieure à 10 mètres, et de préférence supérieure à 12 mètres.

D'autres avantages et caractéristiques ressortiront plus clairement de la description qui va suivre de modes particuliers de réalisation de l'invention, donnés à titre d'exemples non limitatifs, et représentés sur les figures listées ci-dessous.

## FIGURES

La figure 1A représente une première configuration pour mettre en œuvre l'invention, ainsi que les évolutions temporelles de signaux générés respectivement par deux capteurs d'une onde ultrasonore, suite à la survenue d'un défaut affectant un câble électrique.
La figure 1B représente la formation d'une onde ultrasonore et sa propagation vers les deux capteurs acoustiques représentés sur la figure 1A.
La figure 1C représente une autre configuration du premier mode de réalisation, dans laquelle le défaut survient à proximité d'un capteur.

La figure 1D montre une deuxième configuration permettant la mise en œuvre de l'invention, et des évolutions temporelles de signaux générés respectivement par un capteur électrique et un capteur d'une onde acoustique, suite à la survenue d'un défaut affectant un câble électrique.

La figure 2 trace l'évolution de la vitesse de propagation d'une onde ultrasonore dans un câble électrique, ainsi que l'atténuation de cette vitesse en fonction de la distance de propagation de l'onde le long du câble.

La figure 3A schématise les étapes d'un mode de réalisation de l'invention. La figure 3B schématise les étapes d'un autre mode de réalisation de l'invention.

La figure 4A montre des évolutions temporelles de signaux détectés par deux capteurs acoustiques lors d'essais expérimentaux.

Les figures 4B et 4C montrent des évolutions temporelles d'un signal électrique et d'un signal acoustique résultant d'essais expérimentaux.

## EXPOSE DE MODES DE REALISATION PARTICULIERS

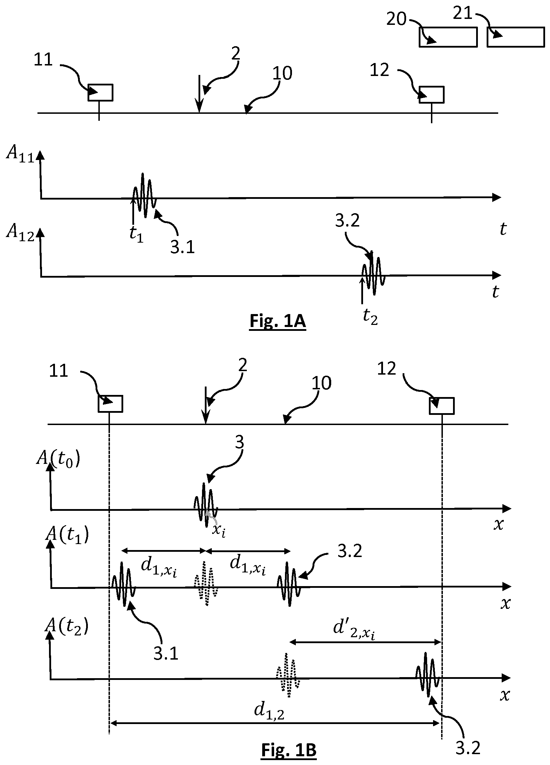

Les figures 1A et 1B représentent une première configuration permettant une mise en œuvre de l'invention. Un câble 10 s'étend entre un premier capteur acoustique 11 et un deuxième capteur acoustique 12. Le terme capteur acoustique désigne un capteur apte à détecter une onde acoustique se propageant dans un milieu, en l'occurrence le câble 10. Le premier capteur acoustique 11 et le deuxième capteur acoustique 12 sont reliés à un microprocesseur 20. Le microprocesseur 20 est configuré pour exécuter des instructions stockées dans une mémoire 21 pour mettre en œuvre le procédé décrit ci-après. Les capteurs 11, 12 peuvent être reliés au processeur 20 par une liaison filaire ou une liaison sans fil.

Le câble 10 est un câble conducteur d'électricité. Il peut en particulier s'agir d'un câble présentant une âme métallique, par exemple en aluminium ou en cuivre, recouverte d'une gaine isolante tubulaire, le matériau constituant la gaine étant par exemple un plastique souple.

Le câble subit un défaut 2 que l'on cherche à détecter et à localiser. Le défaut 2 affectant le câble 10 peut être de nature électrique, en étant notamment un arc électrique. Le défaut 2 peut également être de nature mécanique, par exemple un choc mécanique exercé sur le câble. Il est matérialisé par une flèche sur les figures 1A à 1D. La survenue du défaut entraîne une formation d'une onde acoustique 3, cette dernière se propageant le long du câble, sous la forme de deux composantes 3.1 et 3.2 se propageant selon deux sens opposés, respectivement vers le premier capteur acoustique 11 et le deuxième capteur acoustique 12. L'onde acoustique est généralement une onde de fréquence ultrasonore, la bande de fréquence étant typiquement comprise entre 30 et 500 kHz. La majeure partie de l'onde acoustique se propageant le long du câble est une onde acoustique dite longitudinale, selon laquelle la pression s'exerce, dans le métal, parallèlement à la direction de propagation. La gaine du câble atténue les ondes acoustiques se formant selon un mode transverse, ces ondes étant des ondes acoustiques de surface.

L'onde acoustique 3 se formant consécutivement au défaut 2 se propage jusqu'au premier et deuxième capteur acoustique. Le premier et le deuxième capteur acoustiques peuvent être des transducteurs piézoélectriques, par exemple un capteur piézoélectrique résonant de type Mistras R15a, particulièrement sensible dans la bande de fréquence 30 kHz - 200 kHz. Les capteurs acoustiques peuvent également être des accéléromètres, ou des capteurs électromécaniques. La mesure de l'onde acoustique est généralement effectuée sur l'âme du câble, une mesure réalisée au niveau de la gaine subissant une atténuation pouvant être préjudiciable à la qualité de la mesure. La première composante 3.1, se propageant vers le premier capteur acoustique 11, est détectée à un premier instant $t_1$ tandis que la deuxième composante 3.2, se propageant vers le deuxième capteur acoustique 12, est détectée à un deuxième instant $t_2$. Sur la figure 1A, on a représenté respectivement les évolutions temporelles de l'amplitude $A_{11}(t)$ et $A_{12}(t)$ du signal mesuré par les premier et deuxième capteurs acoustiques 11 et 12. Une telle configuration est désignée par le terme "acoustique-acoustique".

La figure 1B représente la distribution spatiale de l'onde acoustique 3 et de ses composantes 3.1 et 3.2. Le défaut 2 survient à un instant $t_0$. A cet instant, l'onde acoustique 3 se forme, dont la distribution spatiale est schématisée sur la courbe $A(t_0)$. Une première composante 3.1 de l'onde acoustique 3 se propage vers le premier capteur acoustique 11 et atteint ce dernier au premier instant $t_1$. La distribution spatiale de l'onde acoustique le long du câble au premier instant $t_1$ est schématisée sur la courbe $A(t_1)$, l'onde acoustique initiale 3 étant représentée en pointillés. Si $x_i$ désigne une coordonnée de la position du défaut 2 sur le câble, la composante 3.1 de l'onde acoustique 3 a parcouru une distance $d_1,x_i$, le long du câble, entre les instants $t_0$ et $t_1$. Une deuxième composante 3.2 de l'onde acoustique 3 se propage vers le deuxième capteur acoustique 12 et atteint ce dernier au deuxième instant $t_2$, ce dernier étant postérieur au premier instant $t_1$. La distribution spatiale de l'onde acoustique le long du câble au deuxième instant $t_2$ est schématisée sur la courbe $A(t_2)$, la deuxième composante 3.2, au premier instant $t_1$ étant représentée en pointillés. Entre les instants $t_1$ et $t_2$, la deuxième composante 3.2 de l'onde acoustique 3, parcourt, le long du câble, une distance $d'_2,x_i$.

Si v désigne la vitesse de propagation de l'onde acoustique le long du câble, et plus précisément entre le défaut 2 et le deuxième capteur acoustique 12, la distance d'$_{2,x_i}$ parcourue par l'onde acoustique entre le premier instant $t_1$ et le deuxième instant $t_2$ peut s'exprimer selon l'expression :

$$d'_{2,x_i} = v \times \Delta t \ (1)$$

avec $\Delta t = t_2 - t_1$

La distance $d_{1,x_i}$ parcourue par l'onde jusqu'à sa détection par le premier capteur 11 peut s'exprimer selon l'expression :

$$d_{1,x_i} = \frac{d_{1,2} - d'_{2,x_i}}{2} = \frac{d_{1,2} - v \times \Delta t}{2} \ (2)$$

et

$$d_{1,x_i} = x_{11} - x_i \ (2')$$

$d_{1,2}$ correspond à la distance entre le premier capteur 11 et le deuxième capteur 12. Selon ce mode de réalisation, $d_{1,2}$ est non nulle. Cette distance doit être connue.

La position $x_{11}$ sur le câble, du premier capteur 11 étant connue, l'expression (2') permet d'obtenir la position $x_i$ du défaut sur le câble.

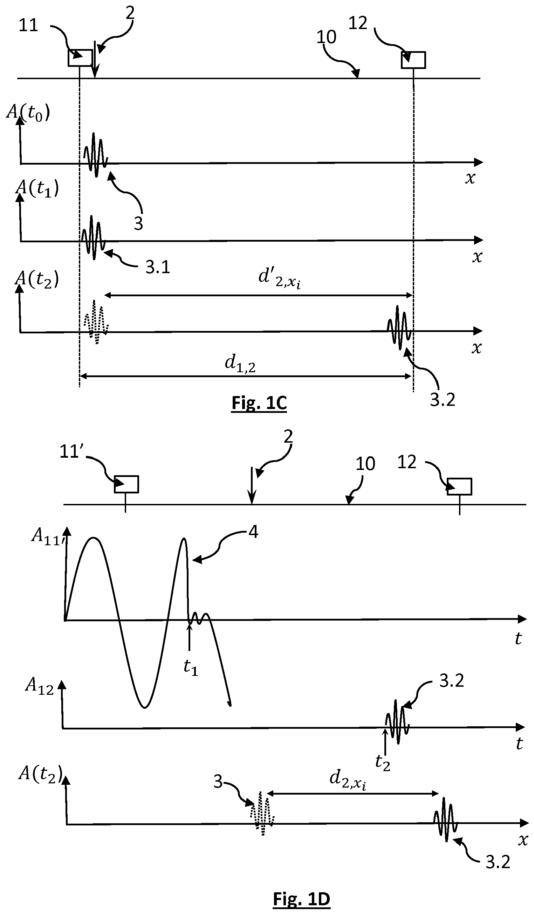

La figure 1C représente un exemple dans lequel le défaut 2 est positionné au niveau du premier capteur 11. Dans ce cas, $d'_{2,x_i} = d_{1,2}$ et selon l'équation (2), $d_{1,x_i} = 0$.

La détection d'un défaut 2 par un capteur acoustique présente l'avantage de permettre la détection d'une onde ultrasonore résultant d'un défaut électrique, par exemple un arc électrique, ou d'un défaut mécanique, de type choc ou cassure. Ainsi, l'utilisation d'un capteur acoustique permet à la fois une détection d'un défaut d'origine électrique ou mécanique. Le mode de réalisation précédemment exposé convient particulièrement à la détection et à la localisation d'un défaut 2 situé entre les deux capteurs acoustiques. Dans cette configuration, les termes premier capteur acoustique et deuxième capteur acoustique désignent respectivement le capteur situé, le long du câble 10, le plus proche et le plus éloigné du défaut.

Il n'est cependant pas nécessaire que les deux capteurs utilisés soient des capteurs acoustiques. L'un des capteurs peut être un capteur électrique. Par capteur électrique, on entend un capteur mesurant un paramètre électrique d'un courant électrique circulant dans le câble. Il peut notamment s'agir d'une mesure d'une tension ou de l'intensité d'un courant électrique, comme décrit dans WO2014/001466, cité en lien avec l'art antérieur, voire d'une évolution de la résistance électrique entre deux points du câble. La figure 1D représente une configuration, dite électrique-acoustique dans lequel le premier capteur 11' est un capteur électrique tandis que le deuxième capteur 12 est un capteur acoustique. La survenue d'un défaut 2 dans le câble 10 induit une brusque variation 4 d'un paramètre électrique au niveau du défaut, cette variation se propageant le long du câble 10 à une vitesse que l'on peut considérer égale à la vitesse de la lumière. Cette variation 4 est mesurée par le premier capteur 11' simultanément à la survenue du défaut, le décalage temporel entre l'apparition du défaut et sa mesure par le premier capteur 11' étant négligeable. Ainsi, le premier instant $t_1$ de détection du défaut 2 par le premier capteur 11' correspond à l'instant $t_0$ de survenue du défaut 2. La position $x_i$ du défaut 2 dans le câble 11' peut être déterminée par rapport à la position $x_{12}$ du deuxième capteur 12, selon l'expression :

$$d_{2,x_i} = v \times \Delta t \ (3)$$

avec

$$d_{2,x_i} = x_{12} - x_i \ (4)$$

$v$ représente ici la vitesse de propagation de l'onde acoustique le long du câble, entre le défaut 2 et le deuxième capteur acoustique 12. $\Delta t = t_2 - t_1$, comme décrit en lien avec le précédent mode de réalisation. Cela correspond à l'intervalle temporel entre la détection du défaut 2 par le premier capteur 11' et la détection du défaut 2 par le deuxième capteur 12. Selon ce mode de réalisation, $\Delta t = t_2 - t_0$ car $t_1$ peut être considéré comme correspondant à l'instant de survenue du défaut $t_0$.

La position $x_{12}$ sur le câble du deuxième capteur 12 étant connue, l'expression (4) permet d'obtenir la position $x_i$ du défaut sur le câble.

Sur la figure 1D, on a représenté :

- l'évolution temporelle $A_{11,}(t)$ d'un signal mesuré par le capteur électrique 11' ;
- l'évolution temporelle $A_{12}(t)$ d'un signal mesuré par le capteur acoustique 12 ;
- la distribution spatiale de l'onde acoustique 3.2 le long du câble, à l'instant $t_2$, l'onde acoustique 3 à l'instant $t_0$ étant représentée en pointillés. Une composante 3.1 de l'onde acoustique 3 se propage également vers le capteur électrique 11' mais cette dernière n'étant pas détectée, elle n'est pas représentée sur la figure 1D.

De préférence, dans un tel mode de réalisation, le capteur acoustique 12 est disposé à une extrémité du câble. En effet, à défaut, si la distance entre le défaut et le deuxième capteur peut être établie selon l'expression (3), une incertitude subsiste sur la position du défaut par rapport au capteur, le défaut pouvant se situer, à la distance $d_{2,x_i}$ calculée, en amont ou en aval du capteur acoustique. Les termes amont et aval s'entendent en considérant le sens de propagation du courant électrique dans le câble. Une telle incertitude n'existe pas lorsque le capteur acoustique est placé à l'extrémité du câble. Dans le cas contraire, il est préférable de disposer d'un moyen supplémentaire pour lever l'incertitude quant à la position du défaut par rapport au capteur acoustique 12. Selon ce mode de réalisation, le deuxième capteur 12 peut être positionné au même endroit que le premier capteur 11'.

Quelle que soit la configuration adoptée, la détection, par un capteur acoustique, de l'onde acoustique résultant de la survenue d'un défaut peut être réalisée en déterminant l'instant auquel l'intensité du signal mesuré par le capteur dépasse un certain seuil de détection. Ce seuil de détection peut être une valeur prédéterminée ou, et de préférence, une valeur dépendant de l'écart type de bruit $\sigma$, mesuré en l'absence de propagation de l'onde acoustique. L'écart type de bruit peut être périodiquement mesuré et le seuil de détection peut être considéré comme étant égal à $n$ fois l'écart-type, $n$ étant un réel positif, avec par exemple $n = 5$. La détection peut également être effectuée comme décrit dans FR3046232 cité en lien avec l'art antérieur.

Dans le deuxième exemple, la détection, par un capteur électrique 11, de la variation du paramètre électrique induite par le défaut peut être obtenue par le calcul d'une dérivée de l'évolution temporelle du paramètre considéré. Le seuil de détection peut être une valeur seuil de la dérivée.

Contrairement au premier mode de réalisation, l'utilisation d'un capteur électrique ne permet pas la détection d'un défaut mécanique, de type choc mécanique ou rupture. Le mode de réalisation exposé sur la figure 1D se limite donc à la détection d'un défaut d'origine électrique.

On remarque que dans le premier mode de réalisation, le procédé détermine une distance entre le premier capteur 11 et le défaut 2. Dans le deuxième mode de réalisation, le procédé détermine une distance entre le deuxième capteur 12 et le défaut 2.

Quel que soit le mode de réalisation, la localisation du défaut suppose une prise en compte de la vitesse v de propagation de l'onde acoustique le long du câble, et plus précisément la vitesse de propagation de l'onde acoustique entre le défaut 2 et le deuxième capteur 12, comme il en ressort des expressions (2) et (3). Le deuxième capteur est le capteur détectant le défaut à un instant de détection $t_2$ postérieur ou égal au premier instant de détection $t_1$. Dans la configuration acoustique-acoustique, le deuxième capteur 12 est le capteur acoustique le plus éloigné du défaut. Dans la configuration électrique-acoustique, le deuxième capteur 12 est le capteur acoustique.

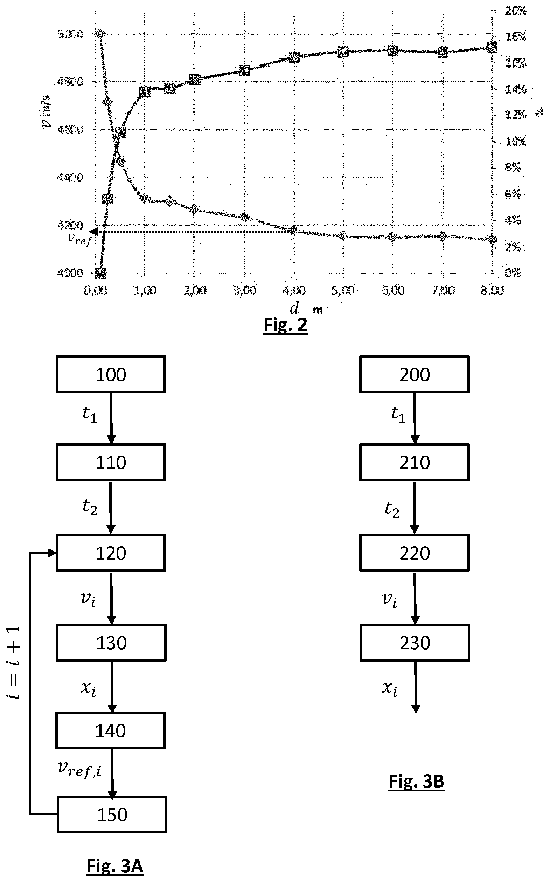

Dans l'art antérieur, une telle vitesse est considérée comme constante, et en particulier indépendante de la distance entre le défaut et capteur acoustique détectant l'onde acoustique résultant de ce défaut. Par exemple, dans une tige d'aluminium, de géométrie similaire à celle d'un câble, la vitesse de propagation d'une onde acoustique est fréquemment considérée égale à 5000 m.s$^{-1}$. Dans la demande WO2014/001466, la vitesse de propagation de l'onde acoustique dans un câble de cuivre est considérée égale à 3350 m/s. Cependant, dans un câble électrique, la vitesse de propagation d'une onde acoustique n'est pas constante. En effet, la gaine isolante recouvrant l'âme du câble a une influence sur la vitesse de propagation de l'onde acoustique, et en particulier dans les premiers mètres à partir du défaut, c'est-à-dire pour des faibles distances de propagation. Cette influence est illustrée sur la figure 2, qui représente l'évolution de la vitesse de propagation v d'une onde acoustique en fonction de la distance de propagation d par rapport au point de départ de l'onde acoustique. Cette évolution est représentée par la courbe dont les marques sont des losanges.

La courbe de la figure 2 a été obtenue en utilisant une configuration telle que celle représentée sur la figure 1C. Deux capteurs acoustiques Mistras R15a ont été disposés le long d'un câble. Un défaut 2 a été généré à proximité immédiate du premier capteur 11, de telle sorte que l'instant de détection de l'onde acoustique $t_1$ par le premier capteur 11 puisse être considéré comme synchrone de la survenue du défaut. La distance $d_{1,2}$ était variable, correspondant à la distance de propagation d de l'onde acoustique 3.2 résultant du défaut et se propageant vers le deuxième capteur 12. A chaque distance $d_{1,2}$ La vitesse de propagation v a été obtenue selon l'expression :

$$v = \frac{d_{1,2}}{\Delta t} \ (5)$$

avec $\Delta t = t_2 - t_1$, où $t_2$ correspond à l'instant de détection de l'onde acoustique 3.2 par le deuxième capteur 12.

Le défaut 2 a été généré selon une méthode dite de la mine de crayon cassée, usuellement désignée par l'acronyme anglosaxon PLB, signifiant "Pencil Lead Break". Cette méthode est décrite dans la publication Sausse "Investigation of pencil lead break as acoustic emission sources", Acoust. Emission, 29 (2011), pp184-196. Le diamètre et la longueur de la mine utilisée étaient respectivement de 0.5 mm et 3 mm, la mine de crayon étant de type 2H, et de diamètre 3.2 mm. Le câble utilisé était un câble d'aluminium AD10 multibrin, recouvert d'une gaine annulaire de téflon, d'épaisseur 0.3 mm. L'angle de contact de la mine était de 45°.

Sur la courbe de la figure 2, on observe une réduction significative de la vitesse de propagation v au fur et à mesure que la distance de propagation d augmente, cette réduction étant attribuée à un effet d'amortissement produit par la gaine. Lorsque la distance de propagation est inférieure à 1 mètre, la vitesse de propagation v décroît rapidement. Cette décroissance correspond à une absorption, par la gaine, de modes de propagation de l'onde acoustique de type transverse et de surface. Au-delà d'une distance de propagation de 1 mètre, la décroissance de la vitesse de propagation v est moins prononcée. Au-delà de 4 ou 5 mètres, la vitesse de propagation v se stabilise à une valeur dite stabilisée $v_{st}$, cette dernière étant dans cet exemple proche de 4160 m.s$^{-1}$. Sur la même courbe, on a également représenté le pourcentage de perte de vitesse en fonction de la distance de propagation, qui correspond au tracé avec des marques de forme carrée.

L'évolution de la vitesse de propagation v en fonction de la distance de propagation, représentée sur la figure 2, dépend de la nature du câble et en particulier les matériaux et les dimensions de l'âme conductrice et la gaine isolante. Ainsi, à chaque câble considéré, on peut établir une fonction de propagation f, telle que représentée sur la figure 2, permettant d'associer une vitesse de propagation $v_{ref}$, dite de référence, d'une onde acoustique se propageant dans le câble, en fonction de la distance de propagation d de l'onde. On a représenté, sur la figure 2, une vitesse de référence correspondant à une distance de propagation de 4 mètres.

Une localisation précise d'un défaut dans un câble suppose une prise en compte de la vitesse de propagation v de l'onde acoustique entre le défaut et un capteur acoustique, en particulier lorsque la distance entre le défaut 2 et le deuxième capteur 12 est inférieure à 4 ou 5 mètres. Cependant, la distance entre le défaut et le deuxième capteur 12 n'est pas connue a priori. C'est pourquoi un aspect de l'invention consiste à estimer de façon itérative la position d'un défaut, en prenant en compte l'évolution de la vitesse de propagation, telle que décrit en lien avec la figure 3A.

La figure 3A schématise les principales étapes d'un procédé permettant la localisation de la position du défaut, le procédé pouvant mettre en œuvre la configuration "acoustique - acoustique" décrite en lien avec les figures 1A à 1C, ou la configuration "électrique-acoustique" décrite en lien avec la figure 1D.

Au cours d'une étape 100, le premier capteur 11 détecte l'onde acoustique 3.1, à un premier instant $t_1$. Au cours d'une étape 110, le deuxième capteur 12 détecte l'onde acoustique 3.2 à un deuxième instant $t_2$, postérieur au premier instant $t_1$ ou égal à ce dernier.

Les étapes 120 à 150, décrites ci-après, sont effectuées de façon itérative, l'indice i désignant le rang de chaque itération. Cet indice est un entier supérieur ou égal à 1. Le procédé peut ne comporter qu'une itération.

Au cours d'une étape 120, on prend en compte une vitesse de propagation $v_i$ de l'onde acoustique dans le câble, entre le défaut et le deuxième capteur 12. Lors de la première itération $i = 1$, la vitesse $v_{i=1}$ prise en compte est définie a priori, par exemple 5000 m.s$^{-1}$.

Au cours d'une étape 130, le processeur 20 détermine une position $x_i$ du défaut sur le câble, en appliquant, selon la configuration mise en œuvre, les équations (2) et (2') ou l'équation (3), en se basant sur la vitesse de propagation $v_i$ prise en compte lors de l'étape 120.

Au cours d'une étape 140, on détermine une vitesse de propagation dite de référence, correspondant à position $x_i$ du défaut déterminée lors de l'étape 130.

Plus précisément, il s'agit de déterminer la vitesse de propagation de l'onde connaissant la distance de propagation entre le défaut 2 et le deuxième capteur 12. Cette vitesse de propagation, dite vitesse de propagation de référence, peut être établie en se basant sur la fonction de propagation f précédemment évoquée. La fonction de propagation f peut être établie à partir de données expérimentales telles que représentées sur la figure 2. L'étape 140 peut notamment comporter les sous-étapes suivantes :

- on établit la distance $d_{x_i,2}$ entre la position $x_i$ du défaut estimée, lors de l'étape 130, et le deuxième capteur 12 ;
- à l'aide de la fonction f de propagation, on détermine une vitesse de référence correspondant à une distance de propagation égale à $d_{x_i,2}$ : $v_{ref,i} = f(d_{x_i,2})$ (6).

Au cours d'une étape 150, on compare la vitesse de référence $v_{ref,i}$, établie lors de l'étape 140, à la vitesse de propagation $v_i$ de l'onde acoustique prise en compte lors de l'étape 120. Il s'agit ici de vérifier que la vitesse de propagation prise en compte correspond bien, à une incertitude près, à la vitesse de référence selon laquelle l'onde acoustique se propage entre le défaut 2 et le deuxième capteur acoustique 12.

- Lorsque $v_{ref,i} \approx v_i$, la position du défaut $x_i$ est validée. Le terme $\approx$ désigne une égalité moyennant la prise en compte d'une incertitude prédéterminée, par exemple 5% ou 10%.
- Lorsque $v_{ref,i} \neq v_i$, les étapes 120 à 150 sont réitérées, en se basant, lors de l'étape 120, sur une vitesse de propagation différente de celle prise en compte lors de la précédente itération.

Lorsque les étapes 120 à 150 sont réitérées, la vitesse de propagation de l'onde, lors de l'étape 120, peut être modifiée selon une séquence préétablie, par exemple en diminuant ou en augmentant peu à peu la vitesse de propagation. De préférence, lorsque $i > 1$ la vitesse de propagation $v_i$ de l'onde prise en compte lors de l'étape 120 est déterminée en fonction de la vitesse de référence $v_{ref,i-1}$ établie lors d'une itération précédente. Par exemple $v_i = v_{ref,i-1}$.

La figure 3B représente un autre mode de réalisation, dans lequel on se base sur une configuration acoustique-acoustique telle que décrite en lien avec les figures 1A à 1C. Selon ce mode de réalisation, le premier capteur acoustique et le deuxième capteur acoustique sont éloignés l'un de l'autre d'une distance supérieure à deux fois la distance nécessaire à l'obtention d'une vitesse de propagation stabilisée $v_{st}$, c'est-à-dire une vitesse de propagation de l'onde acoustique n'évoluant plus significativement par rapport à la distance de propagation, telle que décrite en lien avec la figure 2. On peut par exemple considérer qu'au-delà de 8 mètres, voire 10 mètres, ou davantage, les capteurs acoustiques sont suffisamment éloignés l'un de l'autre de telle sorte que l'onde acoustique atteignant le deuxième capteur 12 se déplace à une vitesse correspondant à la vitesse de propagation stabilisée.

Les étapes de ce mode de réalisation sont à présent décrites. Au cours d'une étape 200, le premier capteur 11 détecte l'onde acoustique 3.1, à un premier instant $t_1$. Au cours d'une étape 210, le deuxième capteur 12 détecte l'onde acoustique 3.2 à un deuxième instant $t_2$, postérieur au premier instant $t_1$. Au cours d'une étape 220, on prend en compte la vitesse de propagation $v_{st}$ stabilisée de l'onde acoustique. Au cours d'une étape 230, la position $x_i$ du défaut est établie, à partir de l'équation (2), par :

$$d_1, x_i = \frac{d_{1,2} - v_{st} \times \Delta t}{2} \quad (7)$$

Lorsque deux capteurs acoustiques sont mis en œuvre, selon la configuration acoustique-acoustique, le premier mode de réalisation est préférable tant que la vitesse de propagation de l'onde acoustique, entre le défaut 2 et le deuxième capteur acoustique 12, n'a pas atteint la vitesse de propagation stabilisée $v_{st}$ préalablement définie. Ainsi, dans une configuration acoustique-acoustique, le premier mode de réalisation est avantageux tant que la distance entre les deux capteurs acoustiques est inférieure à 10m, voire 15 m. Dans le cas contraire, le deuxième mode de réalisation est plus avantageux.

Essais expérimentaux.

Le mode de réalisation décrit sur la figure 3A a été mis en œuvre en utilisant le câble précédemment décrit, selon une configuration acoustique-acoustique. Les capteurs acoustiques 11 et 12 étaient éloignés l'un de l'autre d'une distance de 5 mètres. Les capteurs acoustiques étaient des capteurs piézoélectriques Mistras R15a tels que précédemment décrits. Le défaut 2 a été simulé selon un procédé de mine de crayon cassée (PLB) décrit en lien avec la figure 2.

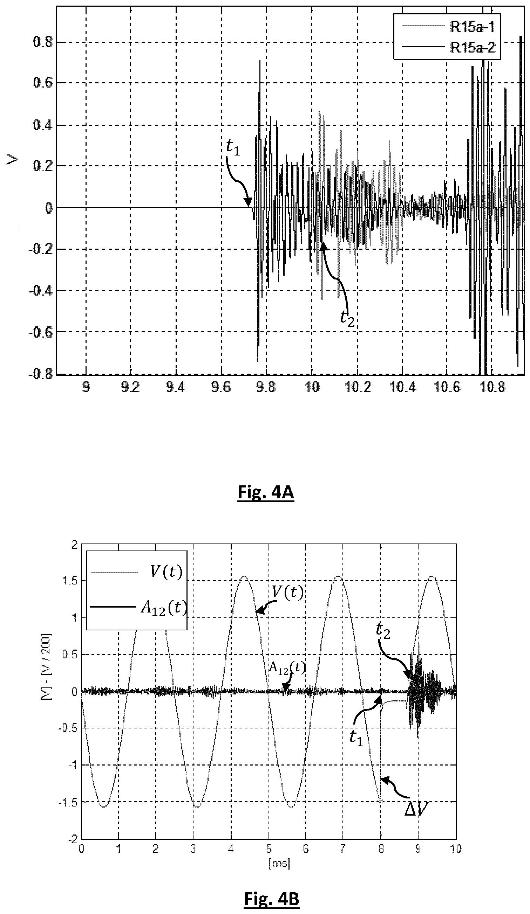

La figure 4A représente l'évolution temporelle de l'amplitude des signaux délivrés par chaque capteur. Sur cette courbe, les capteurs acoustiques sont référencés R15a-1 et R15a-2. Un seuillage, par exemple à $5\sigma$, a été appliqué de façon à déterminer les instants de détection $t_1$ et $t_2$. Cinq essais ont été réalisés. Le tableau 1 représente, pour chaque essai, la distance réelle $d_1, x_i$ - *real* son estimation par la mesure $d_1, x_i$ ainsi que l'écart $\Delta$ entre la valeur mesurée et la valeur réelle.

Tableau 1

| test | $d_1, x_i$ - *real* (m) | $d_1, x_i$ - *mes* (m) | $\Delta$ (m) |
|------|------|------|------|
| 1 | 1.000 | 1.009 | 0.009 |
| 2 | 1.500 | 1.506 | 0.006 |

(suite)

| test | $d_1, x_i$ - *real* (m) | $d_1, x_i$ - *mes* (m) | $\Delta$ (m) |
|------|------|------|------|
| 3 | 2.300 | 2.302 | 0.002 |
| 4 | 3.000 | 3.008 | 0.008 |
| 5 | 4.300 | 4.314 | 0.014 |

Les écarts observés démontrent que le procédé permet une estimation précise de la localisation du défaut. Deux itérations ont été suffisantes pour parvenir aux résultats $d_1, x_i$ - *mes*.

Une autre série d'essais a été effectuée en mettant en œuvre une configuration électrique-acoustique telle que représentée sur la figure 1D. Le capteur électrique 11' est un voltmètre, mesurant une tension $V$ entre le métal conducteur du câble et une masse. Le capteur acoustique 12 est un capteur Mistras WSα. La distance entre les deux capteurs était de 10 mètres. La figure 4B représente les évolutions temporelles des signaux $V(t)$ et $A_{12}(t)$ respectivement mesurés par le capteur électrique et le capteur acoustique. On observe notamment la variation $\Delta V$ de la tension mesurée par le capteur électrique 11', permettant la détermination du premier instant de détection $t_1$. Cet instant de détection a été déterminé en calculant une dérivée temporelle du signal mesuré par le capteur électrique 11'.

Le tableau 2 représente, pour chaque essai, la distance réelle $d_2, x_i$ - *real,* entre le capteur acoustique et le défaut, ainsi que son estimation par la mesure $d_2, x_i$ - *mes* (m) ainsi que l'écart $\Delta$ entre la valeur mesurée et la valeur réelle

Tableau 2

| test | $d_2, x_i$ - *real* (m) | $d_2, x_i$ - *mes* (m) | $\Delta$ (m) |
|------|------|------|------|
| 6 | 3.06 | 3.16 | 0.1 |
| 7 | 8.00 | 7.93 | 0.07 |
| 8 | 10 | 9.89 | 0.11 |

On observe à nouveau que le défaut est localisé avec précision.

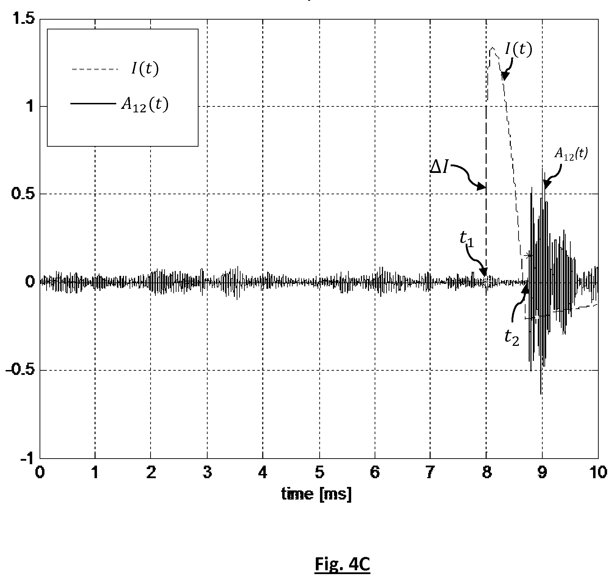

Un autre essai a été déterminé, en mettant en œuvre la configuration électrique - acoustique, le premier capteur électrique étant un ampèremètre, mesurant une évolution temporelle de l'intensité $I$ du courant circulant dans le câble. La figure 4C illustre la détection du premier instant de détection $t_1$, correspondant à une variation de l'intensité $\Delta I$, et du deuxième instant de détection $t_2$.

L'invention pourra être mise en œuvre pour détecter et localiser des défauts survenant dans des circuits électriques, par exemple dans des habitats ou des installations industrielles. Il peut par exemple s'agir de circuits électriques formant des coffrets électriques. L'invention peut également s'appliquer au contrôle d'équipements électriques embarqués, par exemple dans des faisceaux de câbles embarqués dans un véhicule ou un aéronef. Elle peut également concerner le contrôle d'équipements électriques tels des batteries. Elle pourra également s'appliquer à la détection de défauts survenant dans des câbles enterrés ou immergés.

**Revendications**

1. Procédé de détection et de localisation d'un défaut (2) affectant un câble (10), le câble étant destiné à conduire un courant électrique, le procédé comportant les étapes suivantes :

   a) disposition d'un premier capteur (11,11') et d'un deuxième capteur (12), le premier capteur étant apte à détecter la survenue d'un défaut (2) dans le câble, le deuxième capteur étant apte à détecter une onde acoustique (3) se propageant le long du câble, suite à la survenue du défaut dans le câble;
   b) détection de la survenue du défaut

   - par le premier capteur, à un premier instant ($t_1$),
   - et par le deuxième capteur, à un deuxième instant ($t_2$), postérieur ou identique au premier instant ;

   c) prise en compte d'une vitesse de propagation ($v_1,v_i$) de l'onde acoustique générée par le défaut ;
   d) estimation d'une position ($x_1,x_i$) du défaut (2) en fonction du premier instant ($t_1$) et du deuxième instant ($t_2$), en se basant sur la vitesse de propagation résultant de l'étape c); **caractérisé en ce qu'**il comprend en outre les étapes suivantes:
   e) détermination d'une vitesse de propagation de référence ($v_{ref}(x_1),v_{ref}(x_i)$) en fonction de la position ($x_1,x_i$) du défaut (2) estimée lors de l'étape d), et comparaison de la vitesse de référence avec la vitesse de propagation prise en compte lors de l'étape c) ;
   f) en fonction de la comparaison,

   ▪ validation de la position résultant de l'étape d) ;
   ▪ ou réitération des étapes c) à f) en ajustant, lors de l'étape c) la vitesse de propagation prise en compte.

2. Procédé selon la revendication 1, dans lequel le premier capteur est un capteur acoustique (11), apte à détecter l'onde acoustique (3, 3.1) se propageant le long du câble.

3. Procédé selon la revendication 2, dans lequel lors de l'étape d), l'estimation de la position ($x_1,x_i$) du défaut est obtenue en :

   di) calculant un écart temporel ($\Delta t$) entre le premier instant ($t_1$) et le deuxième instant ($t_2$);
   dii) comparant une distance ($d_{1,2}$) entre le premier capteur (11) et le deuxième capteur (12), le long du câble, à une distance obtenue en multipliant la vitesse de propagation ($v_1, v_i$) de l'onde acoustique, prise en compte lors de l'étape c), par l'écart temporel ($\Delta t$).

4. Procédé selon l'une quelconque des revendications 2 ou 3, dans lequel lors de l'étape d), la position ($x_1, x_i$) du défaut (2) est située entre le premier capteur et le deuxième capteur.

5. Procédé selon la revendication 1, dans lequel le premier capteur est un capteur électrique (11'), apte à mesurer un signal électrique ($V,I$) se propageant le long du câble, ainsi qu'une variation ($\Delta V,\Delta I$) du signal électrique générée par le défaut (2).

6. Procédé selon la revendication 5, dans lequel lors de l'étape d), l'estimation de la position est obtenue en :

   di) calculant un écart temporel ($\Delta t$) entre le premier instant ($t_1$) et le deuxième instant ($t_2$);
   dii) multipliant la vitesse de propagation de l'onde acoustique ($v_1, v_i$), prise en compte lors de l'étape c), par l'écart temporel ($\Delta t$).

7. Procédé selon l'une quelconque des revendications précédentes, dans lequel lors d'une réitération des étapes c) à f), la vitesse de propagation ($v_i$) prise en compte lors de l'étape c) d'une itération correspond à la vitesse de référence ($v_{ref}(x_{i-1})$) déterminée lors de l'étape e) de l'itération précédente.

8. Procédé selon l'une des revendications précédentes, dans lequel lors de l'étape e), la vitesse de référence ($v_{ref}(x_i)$) est déterminée à l'aide d'une fonction de propagation *(f)* décrivant l'évolution de la vitesse de propagation d'une onde acoustique, dans le câble, en fonction de la distance de propagation de l'onde acoustique.

9. Dispositif (1) de détection et de localisation de la position d'un défaut (2) dans un câble (10), le câble étant apte à conduire un courant électrique, le dispositif comportant :

   - un premier capteur (11, 11'), apte à détecter la survenue d'un défaut dans le câble électrique;
   - un deuxième capteur (12) étant apte à détecter une onde acoustique (3) se propageant le long du câble suite à la survenue du défaut dans le câble;

- un processeur (20), relié au premier capteur et au deuxième capteur, et configuré pour exécuter des instructions pour la mise en œuvre des étapes b) à f) du procédé selon l'une quelconque des revendications 1 à 8, à partir de signaux de détection provenant du premier capteur et du deuxième capteur.

10. Dispositif (1) selon la revendication 9, dans lequel le premier capteur (11) est un capteur apte à détecter une onde acoustique se propageant le long du câble suite à la survenue du défaut dans le câble.

11. Dispositif selon la revendication 9, dans lequel le premier capteur (11') est un capteur électrique, apte à mesurer un paramètre électrique relatif au courant circulant dans le câble.

**Patentansprüche**

1. Verfahren zur Erfassung und Lokalisierung eines sich auf ein Kabel (10) auswirkenden Fehlers (2), wobei das Kabel dazu bestimmt ist, einen elektrischen Strom zu leiten, wobei das Verfahren die folgenden Schritte aufweist:

    a) Anordnen eines ersten Sensors (11, 11') und eines zweiten Sensors (12), wobei der erste Sensor das Auftreten eines Fehlers (2) im Kabel erfassen kann, der zweite Sensor eine Schallwelle (3) erfassen kann, die sich nach dem Auftreten des Fehlers im Kabel entlang des Kabels ausbreitet;
    b) Erfassen des Auftretens des Fehlers

        - durch den ersten Sensor zu einem ersten Zeitpunkt ($t_1$),
        - und durch den zweiten Sensor zu einem zweiten Zeitpunkt ($t_2$) nach oder gleich dem ersten Zeitpunkt;

    c) Berücksichtigen einer Ausbreitungsgeschwindigkeit ($v_i$, $v_i$) der vom Fehler erzeugten Schallwelle;
    d) Schätzen einer Position ($x_1$, $x_i$) des Fehlers (2) abhängig vom ersten Zeitpunkt ($t_1$) und vom zweiten Zeitpunkt ($t_2$) basierend auf der aus dem Schritt c) resultierenden Ausbreitungsgeschwindigkeit;

**dadurch gekennzeichnet, dass** es außerdem die folgenden Schritte enthält:

    e) Bestimmen einer Bezugs-Ausbreitungsgeschwindigkeit ($v_{ref}(x_1)$, $v_{ref}(x_i)$) abhängig von der im Schritt d) geschätzten Position ($x_1$, $x_i$) des

Fehlers (2), und Vergleich der Bezugsgeschwindigkeit mit der im Schritt c) berücksichtigten Ausbreitungsgeschwindigkeit;
    f) abhängig vom Vergleich

        • Validieren der aus dem Schritt d) resultierenden Position;
        • oder Wiederholen der Schritte c) bis f) unter Anpassung der berücksichtigten Ausbreitungsgeschwindigkeit im Schritt c).

2. Verfahren nach Anspruch 1, wobei der erste Sensor ein Schallsensor (11) ist, der die sich entlang des Kabels ausbreitende Schallwelle (3, 3.1) erfassen kann.

3. Verfahren nach Anspruch 2, wobei im Schritt d) die Schätzung der Position ($x_1$, $x_i$) des Fehlers erhalten wird durch:

    di) Berechnen einer zeitlichen Abweichung ($\Delta t$) zwischen dem ersten Zeitpunkt ($t_1$) und dem zweiten Zeitpunkt ($t_2$);
    dii) Vergleichen eines Abstands ($d_{1,2}$) zwischen dem ersten Sensor (11) und dem zweiten Sensor (12) entlang des Kabels mit einem Abstand, der durch Multiplizieren der im Schritt c) berücksichtigten Ausbreitungsgeschwindigkeit ($v_1$, $v_i$) der Schallwelle mit der zeitlichen Abweichung ($\Delta t$) erhalten wird.

4. Verfahren nach einem der Ansprüche 2 oder 3, wobei im Schritt d) die Position ($x_1$, $x_i$) des Fehlers (2) sich zwischen dem ersten Sensor und dem zweiten Sensor befindet.

5. Verfahren nach Anspruch 1, wobei der erste Sensor ein elektrischer Sensor (11') ist, der ein elektrisches Signal (V, I), das sich entlang des Kabels ausbreitet, sowie eine Änderung ($\Delta V$, $\Delta I$) des vom Fehler (2) erzeugten elektrischen Signals messen kann.

6. Verfahren nach Anspruch 5, wobei im Schritt d) die Schätzung der Position erhalten wird durch:

    di) Berechnen einer zeitlichen Abweichung ($\Delta t$) zwischen dem ersten Zeitpunkt ($t_1$) und dem zweiten Zeitpunkt ($t_2$);
    dii) Multiplizieren der im Schritt c) berücksichtigten Ausbreitungsgeschwindigkeit der Schallwelle ($v_1$, $v_i$) mit der zeitlichen Abweichung ($\Delta t$).

7. Verfahren nach einem der vorhergehenden Ansprüche, wobei bei einer Wiederholung der Schritte c) bis f) die im Schritt c) einer Wiederholung berücksichtigte Ausbreitungsgeschwindigkeit ($v_i$) der Bezugsgeschwindigkeit ($v_{ref}(x_{i-1})$) entspricht, die im Schritt e) der vorhergehenden Wiederholung bestimmt wurde.

**8.** Verfahren nach einem der vorhergehenden Ansprüche, wobei im Schritt e) die Bezugsgeschwindigkeit ($v_{ref}(x_i)$) mit Hilfe einer Ausbreitungsfunktion (f) bestimmt wird, die die Entwicklung der Ausbreitungsgeschwindigkeit einer Schallwelle im Kabel abhängig von der Ausbreitungsentfernung der Schallwelle beschreibt.

**9.** Vorrichtung (1) zur Erfassung und Lokalisierung der Position eines Fehlers (2) in einem Kabel (10), wobei das Kabel einen elektrischen Strom leiten kann, wobei die Vorrichtung aufweist:

    - einen ersten Sensor (11, 11'), der das Auftreten eines Fehlers im Stromkabel erfassen kann;
    - einen zweiten Sensor (12), der eine Schallwelle (3) erfassen kann, die sich nach dem Auftreten des Fehlers im Kabel entlang des Kabels ausbreitet;
    - einen Prozessor (20), der mit dem ersten Sensor und dem zweiten Sensor verbunden und konfiguriert ist, Anweisungen zur Durchführung der Schritte b) bis f) des Verfahrens nach einem der Ansprüche 1 bis 8 ausgehend von Erfassungssignalen auszuleiten, die vom ersten Sensor und vom zweiten Sensor kommen.

**10.** Vorrichtung (1) nach Anspruch 9, wobei der erste Sensor (11) ein Sensor ist, der eine Schallwelle erfassen kann, die sich nach dem Auftreten des Fehlers im Kabel entlang des Kabels ausbreitet.

**11.** Vorrichtung nach Anspruch 9, wobei der erste Sensor (11') ein elektrischer Sensor ist, der einen elektrischen Parameter bezüglich des im Kabel fließenden Stroms messen kann.

**Claims**

**1.** Method for detecting and locating a fault (2) affecting a cable (10), the cable being intended to conduct an electrical current, the method comprising the following steps:

    a) placing a first sensor (11, 11') and a second sensor (12), the first sensor being able to detect the occurrence of a fault (2) in the cable, the second sensor being able to detect an acoustic wave (3) propagating along the cable, following the occurrence of the fault in the cable;
    b) detecting the occurrence of the fault

        - with the first sensor, at a first time ($t_1$),
        - and with the second sensor, at a second time ($t_2$), subsequent or identical to the first time;

    c) taking into account a propagation speed ($v_1$, $v_i$) of the acoustic wave generated by the fault;
    d) estimating a position ($x_1$, $x_i$) of the fault (2) depending on the first time ($t_1$) and on the second time ($t_2$), on the basis of the propagation speed resulting from step c);

wherein the method further comprises :

    e) determining a reference propagation speed ($v_{ref}(x_1), v_{ref}(x_i)$) depending on the position ($x_1, x_i$) estimated in step d) of the fault (2), and comparing the reference speed with the propagation speed taken into account in step c);
    f) depending on the comparison,

        ▪ validating the position resulting from step d);
        ▪ or reiterating steps c) to f) while adjusting, in step c), the propagation speed taken into account.

**2.** Method according to Claim 1, wherein the first sensor is an acoustic sensor (11), able to detect the acoustic wave (3, 3.1) propagating along the cable.

**3.** Method according to Claim 2, wherein, in step d), the position ($x_1$, $x_i$) of the fault is estimated by:

    di) calculating a time difference ($\Delta t$) between the first time ($t_1$) and the second time ($t_2$);
    dii) comparing a distance ($d_{1,2}$) between the first sensor (11) and the second sensor (12), along the cable, to a distance obtained by multiplying the propagation speed ($v_1$, $v_i$) of the acoustic wave, taken into account in step c), by the time difference ($\Delta t$).

**4.** Method according to either one of Claims 2 and 3, wherein, in step d), the position ($x_1$, $x_i$) of the fault (2) is located between the first sensor and the second sensor.

**5.** Method according to Claim 1, wherein the first sensor is an electrical sensor (11'), able to measure an electrical signal ($V, I$) propagating along the cable, and a variation ($\Delta V, \Delta I$) generated by the fault (2) in the electrical signal.

**6.** Method according to Claim 5, wherein, in step d), the position is estimated by:

    di) calculating a time difference ($\Delta t$) between the first time ($t_1$) and the second time ($t_2$);
    dii) multiplying the propagation speed of the acoustic wave ($v_1, v_i$), taken into account in step c), by the time difference ($\Delta t$).

7. Method according to any one of the preceding claims, wherein, in a reiteration of steps c) to f), the propagation speed ($v_i$) taken into account in step c) of an iteration corresponds to the reference speed ($v_{ref}(x_{i-1})$) determined in step e) of the preceding iteration.

8. Method according to one of the preceding claims, wherein, in step e), the reference speed ($v_{ref}(x_i)$) is determined using a propagation function ($f$) describing the variation in the propagation speed of an acoustic wave, in the cable, as a function of the propagation distance of the acoustic wave.

9. Device (1) for detecting and locating the position of a fault (2) in a cable (10), the cable being able to conduct an electrical current, the device comprising:

   - a first sensor (11, 11'), able to detect the occurrence of a fault in the electrical cable;
   - a second sensor (12) being able to detect an acoustic wave (3) propagating along the cable following the occurrence of the fault in the cable;
   - a processor (20), connected to the first sensor and to the second sensor, and configured to execute instructions to implement steps b) to f) of the method according to any one of Claims 1 to 8, on the basis of detection signals coming from the first sensor and the second sensor.

10. Device (1) according to Claim 9, wherein the first sensor (11) is a sensor able to detect an acoustic wave propagating along the cable following the occurrence of the fault in the cable.

11. Device according to Claim 9, wherein the first sensor (11') is an electrical sensor, able to measure an electrical parameter relative to the current flowing through the cable.

**Fig. 1A**

**Fig. 1B**

**Fig. 1C**

**Fig. 1D**

**Fig. 2**

$t_1$

$t_2$

$v_i$

$x_i$

$v_{ref,i}$

$i = i + 1$

**Fig. 3A**

$t_1$

$t_2$

$v_i$

$x_i$

**Fig. 3B**

**Fig. 4A**

**Fig. 4B**

**Fig. 4C**

**EP 3 492 934 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2014001466 A
- WO 2011118923 A
- DE 102010051213

- JP 2001021607 A
- US 2017115256 A
- FR 3046232

**Littérature non-brevet citée dans la description**

- Investigation of pencil lead break as acoustic emission sources. *Acoust. Emission,* 2011, vol. 29, 184-196